# EUROPEAN PATENT SPECIFICATION

(11) **EP 1 382 972 B1**
(45) Date of publication and mention of the grant of the patent: **12.05.2010**
(21) Application number: 02716854.1
(22) Date of filing: 21.03.2002
(51) Int. Cl.: G01R 31/08, G01R 19/155, H02H 11/00

(54) **AUDIBLE ALARM SYSTEM TO PREVENT EARTHING IN HIGH-VOLTAGE CELLS**
HÖRBARES WARNSYSTEM ZUM VERHINDERN DER ERDUNG IN HOCHSPANNUNGSZELLEN
SYSTEME D'ALARME SONORE DE PREVENTION DE MISE A LA TERRE DANS DES CELLULES HAUTE TENSION

(30) Priority: 30.03.2001 ES 200100754
(43) Date of publication of application: 21.01.2004
(73) Proprietor: Grupo Ormazabal, S.A., 48170 Zamudio (Vizcaya) (ES)
(72) Inventor: ORMAZABAL OCERIN, Javier, E-48170 Zamudio (Vizcaya) (ES)
(74) Representative: Carpintero Lopez, Francisco
(86) International application number: PCT/ES2002/000140
(87) International publication number: WO 2002/080124

(56) References cited:
- GB-A- 2 310 728
- US-A- 4 223 306
- DATABASE WPI Week 200062, Derwent Publications Ltd., London, GB; AN 2000-639600, XP002972930 & EP 1 046 918 A (SCHNIER ELEKTROSTATIK GMBH) 25 October 2000
- DATABASE WPI Week 199950, Derwent Publications Ltd., London, GB; AN 1999-582449, XP002972931 & EP 0 949 735 A (SCHNIER ELEKTROSTATIK GMBH) 13 October 1999
- DATABASE WPI Week 199622, Derwent Publications Ltd., London, GB; AN 1996-215945, XP002972932 & JP 8 079 962 A (TAISEI CONSTR CO LTD, TOGAMI ELECTRIC MFG) 22 March 1996
- DATABASE WPI Week 199512, Derwent Publications Ltd., London, GB; AN 1995-086119, XP002972933 & JP 7 012 856 A (NEC CORPORATION) 17 January 1995

## Description

### OBJECT OF THE INVENTION

The present invention relates to an alarm system specifically conceived to prevent an improper earthing of a high-voltage cell when the latter is electrified.

The object of the invention is to provide an audible and effective alarm that clearly warns the worker that an improper operation is being performed, so that before it is executed the corresponding safety measures can be taken, namely disconnection of the cell from the voltage source.

### BACKGROUND OF THE INVENTION

Generally, equipment installed in high-voltage grids allow grid connection and disconnection operations, as well as earthing of various of its parts.

As the actions on these equipments are manual there is a considerable number of errors in their execution. Among these stands out the earthing of an electrified line by a mistake in the maneuver.

This results in a triphasic short-circuit with an earthed component, producing a strong electrodynamic demand on the grid and some extent of degradation of the equipment, as well as a potential risk for the people and property in the installation.

Hitherto used to prevent this type of error are optical systems indicating the presence of voltage in cells with high-voltage gear, so that a lamp, for example, will remain lit in the presence of voltage and off when there is none, so that in principle the operator can be aware of whether it is possible to perform the earthing operation.

However, practice has shown that this light indication system is not completely effective, as the signal is often overlooked by the operator, so that to this date and in order to minimize the effects of these mistakes the measures have centered on a greater sturdiness of the equipment that may be damaged.

In addition to the above-described problems, derived from mistakes in the earthing operation of an electrified high-voltage cell, it must be added that this implies interruptions in power supply to installations using the same line for their power supply, which results in a reduced quality of service supplied by the grid.

The U.S. patent US-4 223 306 discloses an audible alarm system suitable for preventing earthing of high-ualtage cells.

### DESCRIPTION OF THE INVENTION

The alarm system provided by the invention as defined by claim 1 solves the aforementioned problems in a fully satisfactory manner, not only by means of the audible signal, that due to its nature cannot be ignored, but in addition and fundamentally because said signal appears when the worker is about to perform an improper operation, such as earthing in an electrified condition, that is, the alarm appears before the earthing operation is performed, allowing the operator to stop said operation and proceed to disconnect the voltage from the cell before continuing.

The system is thus not only a signaling system of a dangerous condition of the grid, but also an alarm system that activates only when, under certain grid conditions, the operator commences an improper operation.

For this purpose and more specifically, the device is based on the use of a microswitch established in the power circuit of the audible alarm, which microswitch is normally open and is closed by the actuation lever of the earthing isolator when said lever is introduced, which obviously occurs before the isolator is actuated.

According to another characteristic of the invention, the audible alarm is powered by the high-voltage line, so that for the alarm to turn on two conditions must be met: electrification of the line and insertion of the actuation lever in the earthing isolator. Specifically, in order to obtain the power required for operating the audible alarm the presence of a capacitive and/or resistive insulator bushing or coupling of the high-voltage line is used, which provides the power required to operate the audible alarm when the microswitch is closed.

As regards the audible alarm, it is preferably embodied as an oscillator combined with a piezoelectric buzzer forming a resonant circuit.

### DESCRIPTION OF THE DRAWINGS

As a complement of the description being made and in order to aid a better understanding of the characteristics of the invention, according to a preferred embodiment, a set of drawings is accompanied as an integral part of the description, where for purposes of illustration only and in a non-limiting manner the following is shown:
Figure 1 shows a schematic representation of the basic arrangement of an audible alarm for preventing earthing of high-voltage cells, according to the object of the present invention.
Figure 2 shows a block diagram of the alarm system of the previous figure.

### PREFERRED EMBODIMENT OF THE INVENTION

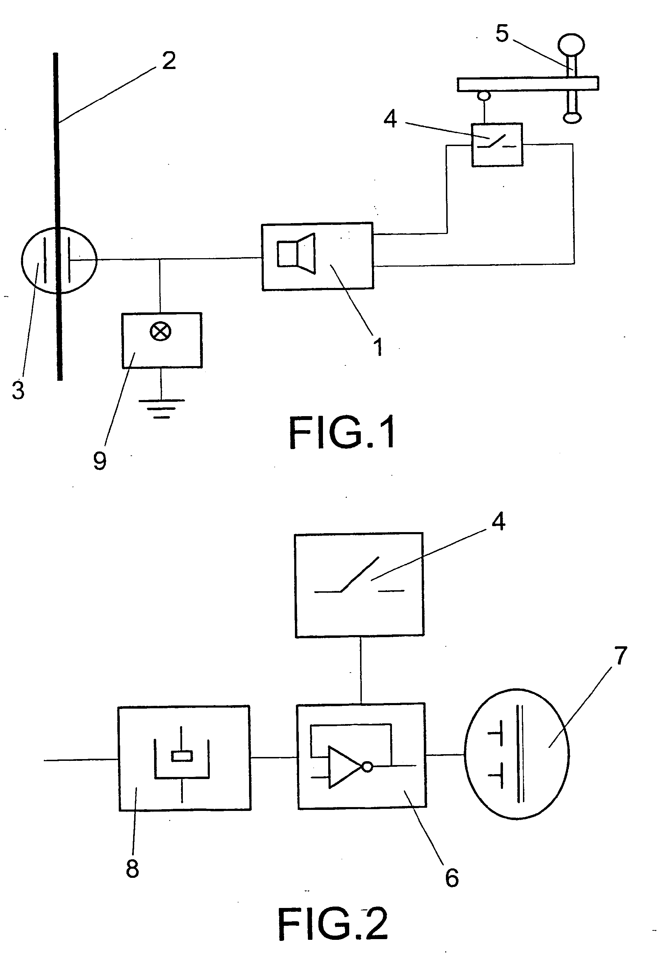

In view of the above described figures and particularly of figure 1, it can be seen that the system disclosed uses an audible alarm (1) powered by the high-voltage line (2), for example through a capacitive bushing (3), with the circuit completed by a normally open microswitch (4), so that in normal working conditions of the cell the audible alarm (1) receives no signal and is thus inoperative.

Said microswitch (4) is activated by the actuation lever (5) of the cell earthing isolator, during the coupling operation of said lever to the isolator shaft, so that the signal occurs before the isolator is actuated, that is, before the cell is earthed.

Obviously, and as mentioned above, in order for the audible signal to occur, that is, so that the audible alarm (1) acts, two conditions must be simultaneously met: the microswitch (4) must be closed, that is, the lever (5) must be coupled to the isolator shaft; and the high-voltage line (2) must be electrified.

The audible alarm (1), as shown in the block diagram of figure 2, is embodied as an oscillator (6) and a ceramic element of a piezoelectric material (7), constituting a controlled resonant circuit that vibrates at regular intervals, so that the discharge of the capacitor (8) that is part of the aforementioned storage and filtering block is extended over time allowing it to be clearly perceived.

In this way, when the earthing shaft starts to be actuated, inserting the lever (5), the microswitch (4) contact closes, closing the circuit and causing the capacitor (8) to discharge the stored energy and supply power to the oscillator (6) and the piezoelectric buzzer (7).

The proper control of the signaling times and the low power consumption of the piezoelectric element (7) provide a high power efficiency.

In addition, the system includes a conventional optical signal (9) indicating the presence of voltage on the line (2) and also connecting the capacitive bushing (3), acting as a complementary conventional indicator that allows the operator to eliminate the voltage on the line (2) before beginning the earthing operation of the cell, so that the audible indication only occurs when the optical signal is not seen by the operator.

## Claims

1. Audible alarm system for preventing earthing of high-voltage cells, which being conceived as a complement of the conventional optical indicator showing the presence of voltage in the corresponding high-voltage line, is
**characterized in that** it is arranged to generate an audible signal before an earthing isolator, comprising an actuation lever (5), is actuated in the case that the optical indication is not seen by the worker, and consists of an audible alarm (1) arranged to be activated through a normally open microswitch (4) that is in turn arranged to be activated by the actuation lever (5) of the earthing isolator when said lever is being coupled to the isolator.

2. - Audible alarm system for preventing earthing of high-voltage cells, according to claim 1, **characterized in that** the audible alarm is powered by the high-voltage line (2), so that for it to be activated two conditions must be simultaneously met: electrification of the line (2); and closing of the microswitch (4) by the actuation lever (5) of the isolator.

3. - Audible alarm system for preventing earthing of high-voltage cells, according to the previous claims,
**characterized in that** the audible alarm (1) consists of a controlled resonant circuit comprised of an oscillator (6) and a ceramic element of a piezoelectric material (7).

4. - Audible alarm system for preventing earthing of high-voltage cells, according to the previous claims,
**characterized in that** the power supply for the audible alarm (1) by the high-voltage line (2) is effectuated with the aid of a capacitive and/or resistive bushing (3).

5. - Audible alarm system for preventing earthing of high-voltage cells, according to claim 4, **characterized in that** the aforementioned capacitive and/or resistive bushing feeds in parallel a conventional optical indicator (9) for presence of voltage in a high-voltage line (2).

## Patentansprüche

1. Akustisches Alarmsystem zum Verhindern des Erdens von Hochspannungszellen, das als eine Ergänzung der herkömmlichen optischen Anzeige vorgesehen ist, die das Anliegen einer Spannung in der entsprechenden Hochspannungsleitung anzeigt, und das **dadurch gekennzeichnet ist, dass** es dafür ausgelegt ist, ein akustisches Signal zu erzeugen, bevor ein Erdungsisolator, der einen Betätigungshebel (5) umfasst, betätigt wird, falls die optische Anzeige durch den Arbeiter übersehen wird, und dass es aus einem akustischen Alarm (1) besteht, der dafür ausgelegt ist, durch einen Schließ-Mikroschalter (4) aktiviert zu werden, der seinerseits dafür ausgelegt ist, durch den Betätigungshebel (5) des Erdungsisolators betätigt zu werden, wenn der Hebel mit dem Isolator gekoppelt wird.

2. Akustisches Alarmsystem zum Verhindern des Erdens von Hochspannungszellen nach Anspruch 1, **dadurch gekennzeichnet, dass** der akustische Alarm über die Hochspannungsleitung (2) mit Strom versorgt wird, so dass für seine Aktivierung zwei Bedingungen gleichzeitig erfüllt sein müssen: Elektrifizierung der Leitung (2); und Schließen des Mikroschalters (4) durch den Betätigungshebel (5) des Isolators.

3. Akustisches Alarmsystem zum Verhindern des Erdens von Hochspannungszellen nach den vorangehenden Ansprüchen, **dadurch gekennzeichnet, dass** der akustische Alarm (1) aus einem gesteuerten Resonanzkreis besteht, der aus einem Oszillator (6) und einem Keramikelement aus einem piezoelektrischen Material (7) besteht.

4. Akustisches Alarmsystem zum Verhindern des Erdens von Hochspannungszellen nach den vorangehenden Ansprüchen, **dadurch gekennzeichnet, dass** die Stromversorgung des akustischen Alarms (1) durch die Hochspannungsleitung (2) mit Hilfe einer kapazitiven und/oder ohmschen Durchführungshülse (3) bewerkstelligt wird.

5. Akustisches Alarmsystem zum Verhindern des Erdens von Hochspannungszellen nach Anspruch 4, **dadurch gekennzeichnet, dass** die oben erwähnte kapazitive und/oder ohmsche Durchführungshülse parallel eine herkömmliche optische Anzeige (9) für das Anliegen einer Spannung in einer Hochspannungsleitung (2) speist.

## Revendications

1. Système à alarme sonore pour empêcher la mise à la terre de cellules haute tension, conçu comme un complément à l'indicateur optique traditionnel indiquant la présence d'une tension sur la ligne à haute tension correspondante, **caractérisé en ce qu'**il est agencé pour engendrer un signal sonore avant l'actionnement du sectionneur de mise à la terre, comprenant un levier d'actionnement (5), pour le cas où l'indication optique n'est pas perçue par l'opérateur, consistant en une alarme sonore (1) agencée pour être activée par l'intermédiaire d'un micro-interrupteur (4) qui à son tour est agencé pour être activé au moyen du levier d'actionnement (5) du sectionneur de mise à la terre lors du couplage dudit levier avec le sectionneur.

2. Système à alarme sonore pour empêcher la mise à la terre de cellules haute tension selon la revendication 1, **caractérisé en ce que** l'alarme sonore est alimentée en énergie par la ligne à haute tension (2) de sorte que, pour son activation, il faut remplir simultanément deux conditions : la mise sous tension de la ligne (2), et la fermeture du micro-interrupteur (4) au moyen du levier d'actionnement (5) du sectionneur.

3. Système à alarme sonore pour empêcher la mise à la terre de cellules haute tension selon les revendications précédentes, **caractérisé en ce que** l'alarme sonore (1) est composée d'un circuit résonnant commandé, comprenant un oscillateur (6) ainsi qu'un élément céramique dans un matériau piézoélectrique (7).

4. Système à alarme sonore pour empêcher la mise à la terre de cellules haute tension selon les revendications précédentes, **caractérisé en ce que** l'alimentation électrique pour l'alarme sonore (1) au moyen de la ligne à haute tension (2) est réalisée à l'aide d'un manchon capacitif et/ou résistif (3).

5. Système à alarme sonore pour empêcher la mise à la terre de cellules haute tension selon la revendication 4, **caractérisé en ce que** ledit manchon capacitif et/ou résistif alimente en parallèle un indicateur optique traditionnel (9) indiquant la présence d'une tension sur une ligne à haute tension (2).
